(19) Europäisches Patentamt
European Patent Office
Office européen des brevets

(11) **EP 1 598 140 A1**

(12) **EUROPÄISCHE PATENTANMELDUNG**

(43) Veröffentlichungstag:
**23.11.2005 Patentblatt 2005/47**

(51) Int Cl.⁷: **B23K 26/14**, H01L 21/00

(21) Anmeldenummer: **04405312.2**

(22) Anmeldetag: **19.05.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(71) Anmelder: **SYNOVA S.A.**
**1024 Ecublens (CH)**

(72) Erfinder:
• **Spiegel, Akos**
**1022 Chavannes (CH)**

• **Richerzhagen, Bernold**
**1025 St-Sulpice (CH)**

(74) Vertreter: **Roshardt, Werner Alfred**
**Keller & Partner**
**Patentanwälte AG**
**Schmiedenplatz 5**
**Postfach**
**3000 Bern 7 (CH)**

(54) **Laserbearbeitung eines Werkstücks**

(57) Bei einer Vorrichtung (1) zum Schneiden von Wafern (2) mit einem in einem Flüssigkeitsstrahl (7) eingekoppelten Laserstrahl (6) in eine Mehrzahl von Chips wird auf der Oberfläche (5) des Wafers (2) eine Flüssigkeitsschicht (9) erzeugt. Dadurch kann verhindert werden, dass sich der beim Laserschneiden entstehende Auswurf wieder auf der Oberfläche des Wafers absetzt. Die Folge ist eine sehr hohe Reinheit der Oberfläche nach dem Schneidvorgang. Die Flüssigkeitsschicht (9) wird insbesondere derart erzeugt, dass sie in einem Arbeitsbereich (10) um den Arbeitspunkt (8) herum dünner ist als ausserhalb des Arbeitsbereichs (10). Dadurch ist gewährleistet, dass die Flüssigkeitsschicht im Arbeitspunkt (8) genügend dünn (14) ist, damit genug Laserenergie für einen Materialabtrag auf die Waferoberfläche gebracht wird und dass sie ausserhalb des Arbeitsbereichs genügend dick (15) ist, damit kein Bereich der Oberfläche (5) des Wafers (2) austrocknet.

Fig. 1

## Beschreibung

### Technisches Gebiet

Die Erfindung betrifft ein Verfahren zur Bearbeitung eines Werkstücks mit einer Laserstrahlung, bei welchem die Laserstrahlung auf eine Oberfläche des Werkstücks gerichtet und das Werkstück in einem Arbeitspunkt bearbeitet wird. Weiter betrifft die Erfindung eine Vorrichtung zur Bearbeitung eines Werkstücks mit einer Laserstrahlung, welche auf eine Oberfläche des Werkstücks richtbar ist, wobei das Werkstück in einem Arbeitspunkt bearbeitbar ist.

### Stand der Technik

Laserstrahlung lässt sich, insbesondere in der Industrie, in vielfältiger Weise zur Bearbeitung verschiedenster Materialien wie beispielsweise Metalle, Kunststoffe oder auch Keramiken verwenden. Die Bearbeitung reicht von Schneiden, Bohren, Schweissen, Materialabtragung oder Markieren.

Aus der WO/9532834 ist eine Vorrichtung bekannt, bei welcher die Laserstrahlung in einen Flüssigkeitsstrahl, der als Lichtleiter wirkt, eingekoppelt wird. Zudem wirkt die Flüssigkeit zugleich auch als Kühlmittel, da sich das Werkstück bei der Bearbeitung mit Laserstrahlung typischerweise erwärmt. Weiter können Dämpfe, Partikel und Aerosole, die bei der Bearbeitung mit der Laserstrahlung entstehen, gebunden bzw. verhindert werden.

Bei der Bearbeitung eines Werkstücks mit Laserstrahlung wird typischerweise Material des Werkstücks abgetragen. Dabei können kleine Materialpartikel, der sogenannte Auswurf, entstehen, welche sich wieder auf der Oberfläche des Werkstücks absetzen bzw. anschmelzen. Je nach Beschaffenheit des Werkstücks und/oder der Werkstückoberfläche bzw. des Auswurfs, kann es vorkommen, dass sich diese wieder fest miteinander verbinden. Diese Ablagerungen auf der Oberfläche des Werkstücks können die Eigenschaften des Endproduktes ungünstig beeinflussen und sind daher in der Regel unerwünscht. Sie müssen daher, falls dies überhaupt möglich ist, mit grossem Aufwand nachträglich wieder entfernt werden.

### Darstellung der Erfindung

Aufgabe der Erfindung ist es, ein dem eingangs genannten technischen Gebiet zugehörendes Verfahren zu schaffen, welches die genannten Nachteile der bekannten Verfahren vermeidet und es insbesondere ermöglicht, Ablagerung des Auswurfs auf der Werkstückoberfläche weitgehend zu verhindern.

Die Lösung der Aufgabe ist durch die Merkmale des Anspruchs 1 definiert. Bei der Bearbeitung eines Werkstücks mit einer Laserstrahlung, bei welchem die Laserstrahlung auf die Werkstückoberfläche gerichtet und das Werkstück in einem Arbeitspunkt bearbeitet wird, wird gemäss der Erfindung auf der Oberfläche des Werkstücks mit einer Flüssigkeit, beispielsweise Wasser, eine Flüssigkeitsschicht erzeugt.

Diese Flüssigkeitsschicht auf der Werkstückoberfläche bewirkt, dass sich der Auswurf, welcher bei der Bearbeitung des Werkstücks mit der Laserstrahlung entsteht, nicht auf der Werkstückoberfläche ablagern kann. Die Flüssigkeitsschicht spült den Auswurf quasi gleich weg.

Bei der Erzeugung der Flüssigkeitsschicht müssen jedoch folgende Bedingungen beachtet werden. Einerseits darf die Dicke der Flüssigkeitsschicht nicht zu klein werden, damit kein Bereich der Werkstückoberfläche austrocknet und damit keine geschmolzenen Materialpartikel oder Partikel mit geschmolzener Umhüllung die Flüssigkeitsschicht durchschlagen. Andererseits darf die Dicke der Flüssigkeitsschicht in dem Arbeitspunkt nicht zu gross sein, da sonst nämlich der Flüssigkeitsstrahl, in welchem die Laserstrahlung eingekoppelt ist, auf dem Weg durch die Flüssigkeitsschicht gestört und die Laserstrahlung aus dem Flüssigkeitsstrahl ausgekoppelt und somit zu stark gestreut wird. Die Folge ist, dass nicht mehr genug Laserleistung in den Bearbeitungsbereich auf die Werkstückoberfläche gebracht werden kann, um dieses zu bearbeiten.

Da die Bearbeitung des Werkstücks oberste Priorität hat, wird die Dicke der Flüssigkeitsschicht derart gewählt, dass genügend Laserleistung auf die Werkstückoberfläche gebracht werden kann.

Je nach der konkreten Anwendung kann es sein, dass sich die obigen Anforderungen an die Flüssigkeitsschicht einander gegenseitig ausschliessen. Bei einer im Wesentlichen überall gleich dicken Flüssigkeitsschicht, kann es nämlich sein, dass die maximal erlaubte Dicke der Flüssigkeitsschicht, damit die Laserstrahlung noch hindurch kommt, kleiner ist als die minimal notwendige Dicke, damit die Werkstückoberfläche nicht stellenweise austrocknet. Wird nämlich eine Flüssigkeitsschicht erzeugt, welche genügend dick ist, dass keine Ablagerungen entstehen können, kommt die Laserstrahlung nicht mehr durch die Flüssigkeitsschicht hindurch. Wird sie jedoch genügend dünn gewählt, dass die Laserstrahlung mit ausreichender Leistung hindurch kommt, ist nicht mehr gewährleistet, dass die betroffenen Oberflächenbereiche des Werkstücks stets mit der Flüssigkeit überspült sind.

Die Flüssigkeitsschicht wird daher mit Vorteil derart erzeugt, dass ihre Dicke nicht überall gleich ist. Die Flüssigkeitsschicht wird bei einer bevorzugten Ausführungsform der Erfindung derart erzeugt, dass ihre Dicke in einem Bereich rund um den Arbeitspunkt, nachfolgend als Arbeitsbereich bezeichnet, kleiner ist als ihre Dicke ausserhalb des Arbeitsbereiches. Die Dicke der Flüssigkeitsschicht im Arbeitsbereich wird nachfolgend als erste Dicke und die Dicke der Flüssigkeitsschicht ausserhalb des Arbeitsbereichs als zweite Dicke bezeichnet.

Indem nun auf der Oberfläche des Werkstücks eine Flüssigkeitsschicht erzeugt wird, welche im Bereich des Bearbeitungspunktes dünner ist als ausserhalb des Arbeitsbereiches, können elegant gleichzeitig beide Forderungen erfüllt werden. Im Arbeitsbereich und insbesondere im Arbeitspunkt wird die Dicke der Flüssigkeitsschicht derart gewählt, dass eine ausreichende Laserleistung auf die Werkstückoberfläche aufgebracht werden kann. Die Dicke der Flüssigkeitsschicht ausserhalb des Arbeitsbereiches wird derart gewählt, dass kein Bereich der Werkstückoberfläche austrocknet und dass keine Materialpartikel in flüssigem, teilweise flüssigem oder festem Zustand die Flüssigkeitsschicht durchdringen können. Gleichzeitig ist auch sicher gestellt, dass sich auf der Oberfläche des Werkstücks in dem Bereich, in welchem es bearbeitet wird, immer eine Flüssigkeitsschicht befindet, welche das Werkstück kühlt. Ebenso können allfällige Dämpfe und Gerüche, welche bei der Bearbeitung des Werkstücks entstehen, effektiv gebunden werden. Die optischen Abbildungsbedingungen werden durch die geringe Dicke der Flüssigkeitsschicht im Arbeitsbereich nicht oder nur unwesentlich beeinflusst bzw. verschlechtert.

Wie die Laserstrahlung auf das Werkstück aufgebracht wird, ist an sich unerheblich. Je nach Anwendung bieten sich verschiedene Methoden an. Eine Möglichkeit besteht darin, den Laserstrahl zu erzeugen und durch die Luft mit einer Fokussierlinse auf die Werkstückoberfläche zu richten. Für die Leitung der Laserstrahlung können aber auch andere Lichtleiter wie beispielsweise optische Fasern benutzt werden. Allerdings besteht bei beiden Arten, neben anderen Nachteilen, das Problem, dass der Laserstrahl die Flüssigkeitsschicht auf der Werkstückoberfläche durchdringen muss oder dass die optischen Eigenschaften der Vorrichtung durch aufspritzende Flüssigkeitstropfen verändert wird. Mit Vorteil wird die Laserstrahlung daher vorzugsweise in einen Flüssigkeitsstrahl eingekoppelt, welcher für die Laserstrahlung als Lichtleiter funktioniert. Diese Art der Laserleitung ist beispielsweise in der oben genannten WO/9532834 beschrieben. Gleichzeitig kann auf diese Weise eine noch bessere Kühlung des Werkstücks im Arbeitspunkt und insbesondere der Schnittkanten erreicht werden. Bei geeigneter Ausbildung des Flüssigkeitsstrahls können auf diese Weise lange, kompakte Laserstrahllängen bis zu einigen Hundert Millimetern erreicht werden. Diese Technik ermöglicht auch schmale, tiefe Schnitte und Bohrungen mit praktisch senkrechten Seitenwänden ohne eine Nachführung des Fokuspunktes der Laserstrahlung. Auch Dämpfe und Gerüche können noch besser gebunden werden.

Zur Erzeugung der Flüssigkeitsschicht können verschiedenste Flüssigkeiten wie beispielsweise Öle, insbesondere Öle aus der Silikongruppe oder Flüssigkeiten, wie sie bei Flüssigkeitsfasern eingesetzt werden, verwendet werden. Typischerweise wird zur Erzeugung der Flüssigkeitsschicht dieselbe Flüssigkeit verwendet wie für den Flüssigkeitsstrahl, in welchen die Laserstrahlung eingekoppelt ist. Mit Vorteil wird Wasser verwendet, welches praktisch überall vorhanden, günstig in der Beschaffung und, im Gegensatz zu Ölen, im Allgemeinen als umweltneutral anzusehen ist.

In Abhängigkeit des Werkstoffmaterials bzw. der Bearbeitungsart kann das Wasser, das für die Erzeugung der Flüssigkeitsschicht verwendet wird, auch noch gereinigt und/oder deionisiert werden. Dadurch kann beispielsweise auch verhindert werden, dass das Werkstück durch das Wasser bzw. irgendwelchen Inhaltsstoffen des Wassers wie z.B. gelöste Salze, verunreinigt wird. Es ist auch möglich, das Wasser (z.B. auch das gereinigte und/oder deionisierte Wasser) elektrisch leitfähig zu machen, indem beispielsweise Kohlendioxid ($CO_2$) eingeleitet wird. Dies ist insbesondere dann von Vorteil, wenn der Auswurf elektrisch geladen ist und/ oder wenn bei der Bearbeitung des Werkstoffs elektrostatische Spannungen entstehen, welche abgeleitet werden sollen.

Die Verwendung einer elektrisch leitfähigen Flüssigkeit wie beispielsweise elektrisch leitfähiges Wasser hat einen weiteren Vorteil. Bauteile, die auf elektrostatische Spannungen empfindlich sind, beispielsweise mikroelektronische Chips, die aus einem Wafer ausgeschnitten werden, können durch die Verwendung einer elektrisch leitfähigen Flüssigkeit nämlich vor elektrostatischen Ladungen geschützt werden, da derartige Ladungen durch die Flüsskeitsschicht abgeleitet werden.

Das erfindungsgemässe Verfahren wird bevorzugt eingesetzt, um Wafer zu bearbeiten. Es wird insbesondere bevorzugt eingesetzt, um aus Siliziumwafern, auf welchen typischerweise eine Vielzahl einzelner Chips realisiert sind, die einzelnen Chips auszuschneiden. Gegenüber dem Zerteilen der Wafer mittels einer Säge lässt sich die thermische und mechanische Beanspruchung der Wafer bei der Bearbeitung mit einem in einem Wasserstrahl geführten Laser deutlich verringern. Dadurch entsteht weniger Ausschuss und es kann effizienter produziert werden.

Die Erfindung eignet sich allerdings auch zum Bearbeiten beliebiger anderer Werkstücke. Die Bearbeitungspalette reicht von Schneiden und Bohren von Stoffen über Markieren bis hin zu leichter Materialabtragung oder Oberflächenbehandlung wie z.B. aufrauhen, strukturieren oder abtragen von Dünnschichten der Werkstückoberfläche. Zur Bearbeitung eignen sich neben Wafern auch nahezu alle anderen Materialien wie beispielsweise Metalle (Stahl, Stahllegierungen, NE-Metalle), aber auch Kunststoffe, Keramiken oder biologische Materialien und Gewebe.

Um die Austrocknung des Werkstücks zu vermeiden, würde es grundsätzlich ausreichen, für eine genügende Dicke, d.h. für eine bestimmte Minimaldicke der Flüssigkeitsschicht, zu sorgen. Um das Austrocknen des Werkstücks möglichst effektiv zu verhindern, wird die zweite Dicke der Flüssigkeitsschicht bei einer vorteilhaften Ausbildungsvariante der Erfindung reguliert, indem beispielsweise die zugeführte und/oder die abfliessende Flüssigkeitsmenge variiert wird. Um die abfliessende Wassermenge zu beeinflussen, kann beispielsweise der Werkstückhalter oder gar das Werkstück selber eine spezielle Form aufweisen. Der Werkstückhalter kann z.B. derart ausgebildet sein, dass sein Rand im Vergleich zum Werkstück erhöht ist, sodass die abfliessende Flüssigkeit bis auf die gewünschte Höhe gestaut wird (konvexe Oberfläche). Ist die Oberfläche hingegen konkav ausgebildet, fliesst die Flüssigkeit schneller ab und die Flüssigkeitsschicht wird dünner.

Die Dicke der Flüssigkeitsschicht wird aber vorzugsweise auch beeinflusst, indem der Flüssigkeit Stoffe zugesetzt werden, welche deren Oberflächenspannung beeinflussen, d.h. je nach Anwendung erhöhen oder erniedrigen. Die Dicke der Flüssigkeitsschicht steigt mit einer Erhöhung der Oberflächenspannung. Je nach verwendeter Flüssigkeit können dies sehr unterschiedliche Stoffe sein. Bei der Verwendung von Wasser können zur Erniedrigung der Oberflächenspannung beispielsweise Tenside beigefügt werden.

Die Erzeugung der Flüssigkeitsschicht kann grundsätzlich auf verschiedene Arten erfolgen. Dies könnte beispielsweise erfolgen, indem zunächst eine regelmässig dicke Schicht erzeugt wird, deren Dicke im Bereich des Arbeitspunktes z.B. durch einen darauf gerichteten Luftstrahl reduziert wird. Wird die Strömungsgeschwindigkeit und der Druck des Luftstrahls geeignet gewählt, verdrängt dieser einen Teil der Flüssigkeit im Arbeitspunkt und schafft auf diese Weise die dünnere Flüssigkeitsschicht im Arbeitsbereich. Bei dieser Variante kann die so erzeugte dünne Flüssigkeitsschicht allerdings Unregelmässigkeiten aufweisen, was zu einer unerwünscht unregelmässigen Bearbeitung des Werkstücks führen kann. Zudem kann auch der Flüssigkeitsstrahl und damit die darin eingekoppelte Laserstrahlung durch einen solchen Luftstrom gestört werden.

Bei einer bevorzugten Variante wird die Flüssigkeitsschicht mit einer ersten Flüssigkeitszuführvorrichtung, beispielsweise einer Düse oder einem Rohr, erzeugt. Die Flüssigkeitsschicht wird derart erzeugt, dass die Flüssigkeit in der Nähe des Arbeitspunktes auf das Werkstück aufgebracht wird. Nachfolgend wird in diesem Zusammenhang von einem aufgebrachten Flüssigkeitsstrahl gesprochen, wobei dieser Begriff einzelne Flüssigkeitsstrahlen oder eine Mehrzahl von Einzelstrahlen beliebigen Querschnitts umfassen soll. D.h. unter diesem Begriff sollen nicht nur Flüssigkeitsstrahlen mit kreisförmigem Querschnitt verstanden werden. Auch Flüssigkeitsvorhänge, wie sie beispielsweise von Schwall- und Fächerdüsen erzeugt werden, sollen unter diesem Begriff subsummiert werden.

Trifft ein solcher Flüssigkeitsstrahl auf die Werkstückoberfläche, fliesst die Flüssigkeit auf der Oberfläche in mehr oder weniger sämtliche Richtungen ab, wobei die Fliessgeschwindigkeit mit zunehmender Entfernung vom Auftreffpunkt abnimmt. Die höchste Fliessgeschwindigkeit und die kleinste Schichtdicke weist die Schicht nahe dem Auftreffpunkt auf. Unterschreitet die Fliessgeschwindigkeit bei zunehmender Entfernung vom Auftreffpunkt eine kritische Geschwindigkeit, erhöht sich die Dicke der Flüssigkeitsschicht.

Bei einer weiteren bevorzugten Ausführungsform der Erfindung wird zur Erzeugung der Flüssigkeitsschicht eine zweite Flüssigkeitszuführvorrichtung, beispielsweise eine oder eine Mehrzahl von Düsen, verwendet. Die zweite Flüssigkeitszuführvorrichtung ist derart ausgebildet, dass auf der Oberfläche des Werkstücks eine träge, regelmässige Flüssigkeitsschicht der zweiten Dicke entsteht, wobei träge in diesem Zusammenhang bedeutet, dass diese Flüssigkeitsschicht zwar fliesst, dass die Fliessgeschwindigkeit jedoch klein ist. Beide Flüssigkeitszuführvorrichtungen können sowohl einzeln als auch in Kombination verwendet werden. Werden sie einzeln verwendet, wird in den meisten Fällen eine gleichmässig dicke Flüssigkeitsschicht erzeugt.

Mit Vorteil werden jedoch beide Flüssigkeitszuführvorrichtungen gleichzeitig verwendet. D.h. mit der zweiten Flüssigkeitszuführvorrichtung wird eine träge Flüssigkeitsschicht der zweiten Dicke erzeugt und gleichzeitig wird nun mit der ersten Flüssigkeitszuführvorrichtung in der Nähe des Arbeitspunktes - wie soeben beschrieben - ein Flüssigkeitsstrahl auf das Werkstück aufgebracht, um im Arbeitsbereich die Dicke der Flüssigkeitsschicht auf die erste Dicke zu reduzieren. Dieser Flüssigkeitsstrahl beeinflusst das Strömungsverhalten der Flüssigkeitsschicht derart, dass diese in dem Arbeitsbereich schneller strömt als ausserhalb dieses Bereichs. Dadurch wiederum reduziert sich die Höhe der Flüssigkeitsschicht im Arbeitsbereich, wobei sie ausserhalb davon im Wesentlichen unbeeinflusst bleibt.

Die Eigenschaften des Flüssigkeitsstrahls, insbesondere dessen Auftreffwinkel auf der Werkstückoberfläche sowie dessen Durchflussmenge werden nun so gewählt, dass das Strömungsverhalten der Flüssigkeitsschicht derart beeinflusst wird, dass sich die Flüssigkeit in dem Arbeitsbereich um den Arbeitspunkt schiessend und ausserhalb dieses Bereichs strömend bewegt. Die Begriffe schiessend und strömend sind in der Hydrodynamik für Flüssigkeiten wohldefiniert. Sie hängen mit der Froude-Zahl Fr zusammen, welche bei einer fliessenden (flachen) Flüssigkeit definiert ist als Verhältnis der Fliessgeschwindigkeit $v$ der Flüssigkeit zur Fortpflanzungsgeschwindigkeit (Wellengeschwindigkeit) $c$ von Schwerewellen, d.h. Oberflächenwellen auf der Flüssigkeitsoberfläche: $FR = v/c$. Die Wellengeschwindigkeit $c$ ihrerseits kann ausgedrückt werden als Wurzel aus dem Produkt der Erdbeschleunigung $g$ und der Flüssigkeitshöhe $h$: $c = \sqrt{g*h}$. Die Froude-Zahl ergibt sich somit zu $FR = v/\sqrt{g*h}$. D.h. eine Flüssigkeit bewegt sich strömend, wenn die Froude-Zahl zwischen 0 und 1 liegt. Ist sie grösser als 1, bewegt sich die Flüssigkeit schiessend. (Bei einem stehenden Gewässer ist die Froude-Zahl folglich gleich 0.)

Durch das Auftreffen des Flüssigkeitsstrahls auf der Flüssigkeitsschicht wird in diesem Bereich das Strömungsgleichgewicht der Flüssigkeitsschicht gestört und die Flüssigkeit fliesst auf der Werkstückoberfläche rund um den Auftreffpunkt des Flüssigkeitsstrahls schiessend ab. Diese schiessende Bewegung wird in einem bestimmten Bereich aufrechterhalten und geht danach nahezu sprunghaft in eine strömende Bewegung der Flüssigkeit über. Diesen mehr oder weniger abrupten Wechsel von schiessender zu strömender Bewegung bzw. umgekehrt nennt man Wechselsprung.

Es gibt viele Parameter um die Eigenschaften des Flüssigkeitsstrahls und damit die Grösse des Arbeitsbereiches sowie die erste Dicke der Flüssigkeitsschicht im Arbeitsbereich zu beeinflussen. Hierzu eignen sich insbesondere sein Durchmesser, sein Auftreffwinkel auf die träge Flüssigkeitsschicht oder seine Durchflussmenge, welche über den Querschnitt mit der Geschwindigkeit und dem Eingangsdruck des Flüssigkeitsstrahls zusammenhängt. Um die Grösse des Arbeitsbereiches sowie die erste Dicke der Flüssigkeitsschicht im Arbeitsbereich zu regulieren, können grundsätzlich sämtliche dieser Parameter praktisch beliebig variiert werden.

Typischerweise wird jedoch der Querschnitt des Flüssigkeitsstrahls während der Bearbeitung des Werkstücks unverändert beibehalten, sodass die Übergänge zwischen strömender und schiessender Flüssigkeit und damit die Grösse des Arbeitsbereiches sowie die erste Dicke der Flüssigkeit bevorzugt durch Variieren des Auftreffwinkels und der Durchflussmenge des Flüssigkeitsstrahls reguliert werden.

Selbstverständlich kann auch der Querschnitt des Flüssigkeitsstrahls variiert werden, indem beispielsweise in einer Bearbeitungspause eine Düse oder ein Rohr durch eine andere Düse oder ein anderes Rohr mit kleinerem oder grösserem Querschnitt ausgewechselt wird.

Die oben genannten Parameter können, wie bereits erwähnt, im Prinzip fast beliebig variiert werden. Der Auftreffwinkel des Flüssigkeitsstrahls, d.h. der Winkel, welcher zwischen der typischerweise horizontalen Oberfläche der Flüssigkeitsschicht und dem Flüssigkeitsstrahl im Auftreffpunkt gebildet wird, kann z.B. zwischen 0 Grad und 90 Grad praktisch beliebig gewählt werden. Wenn bereits eine (träge) Flüssigkeitsschicht vorhanden ist, ist es im Prinzip sogar möglich, den Flüssigkeitsstrahl nicht von oben auf die Flüssigkeitsschicht aufzubringen, sondern quasi unter der Oberfläche einzuspeisen. Allerdings ist es in diesen Fällen schwierig, im Arbeitsbereich die gewünschte schiessende Strömung zu erreichen.

Auch die Durchflussmenge des Wasserstrahls (definiert als Flüssigkeitsmenge pro Zeiteinheit) kann fast beliebig zwischen sehr kleinen Durchflussmengen wie etwa einem Milliliter pro Minute und sehr hohen Durchflussmengen wie etwa zehn Liter pro Minute gewählt werden. Auch der Querschnitt des Flüssigkeitsstrahls kann im Prinzip von sehr klein, beispielsweise 0,01 Millimeter Durchmesser, bis sehr gross, beispielsweise bis 50 Millimeter oder gar 100 Millimeter Durchmesser, gewählt werden.

Um die gewünschten Strömungsverhältnisse mit der schiessenden und der strömenden Bewegung der Flüssigkeit zu erreichen, wird der Flüssigkeitsstrahl bei einer bevorzugten Ausführungsform der Erfindung allerdings derart erzeugt, dass er bei einer Durchflussmenge von 20 Milliliter pro Minute bis 500 Milliliter pro Minute einen Durchmesser zwischen 0,5 Millimeter und 4 Millimeter aufweist, wobei er von oben in einem Auftreffwinkel zwischen 45 Grad und 90 Grad auf die Flüssigkeitsschicht aufgebracht wird.

Die erfindungsgemässe Vorrichtung ist durch die Merkmale des Anspruchs 12 definiert. Neben den Mitteln zur Erzeugung der auf die Oberfläche des Werkstücks gerichteten, in den Flüssigkeitsstrahl eingekoppelten Laserstrahlung umfasst die Vorrichtung gemäss der Erfindung Mittel zur Erzeugung einer Flüssigkeitsschicht auf der Oberfläche des Werkstücks.

Diese Mittel zur Erzeugung der Flüssigkeitsschicht sind vorzugsweise derart ausgebildet, dass die erste Dicke der erzeugten Flüssigkeitsschicht im Arbeitsbereich um den Arbeitspunkt kleiner ist als die zweite Dicke der Flüssigkeitsschicht ausserhalb dieses Arbeitsbereichs.

Bei einer weiteren bevorzugten Ausführungsform der erfindungsgemässen Vorrichtung umfasst diese eine zweite Flüssigkeitszuführvorrichtung. Diese dient zur Erzeugung einer trägen Flüssigkeitsschicht der zweiten Dicke auf der Oberfläche des Werkstücks. Die derart erzeugte Flüssigkeitsschicht wird entweder unverändert als im Wesentlichen überall gleich dicke Flüssigkeitsschicht beibehalten oder es wird, wie vorgängig bereits beschrieben, der schiessende Bereich der Flüssigkeitsschicht erzeugt, indem der erwähnte Flüssigkeitsstrahl in der Nähe des Arbeitspunktes auf die Flüssigkeitsschicht aufgebracht wird.

Die Vorrichtung kann zur Bearbeitung einer Vielzahl von Materialien und zur Durchführung einer Vielzahl von Bearbeitungsarten ausgebildet sein. Ein bevorzugtes Einsatzgebiet für derartige Vorrichtungen ist jedoch das Bearbeiten von Wafern und insbesondere das Ausschneiden einer Vielzahl von Chips aus einem Siliziumwafer.

Zur Erzeugung der Flüssigkeitsschicht umfasst die Vorrichtung vorzugsweise eine erste Flüssigkeitszuführvorrichtung, welche derart ausgebildet ist, dass die Flüssigkeit in der Nähe des Arbeitspunktes auf das Werkstück aufbringbar ist. Auch diese erste Flüssigkeitszuführvorrichtung kann einerseits zur Erzeugung einer gleichmässig dicken bzw. dünnen Flüssigkeitsschicht auf der Werkstückoberfläche verwendet werden. Andererseits kann sie zusammen mit der zweiten Flüssigkeitszuführvorrichtung auch wie beschrieben zur Erzeugung der Flüssigkeitsschicht mit unterschiedlichen Dicken im Arbeitsbereich bzw. ausserhalb davon verwendet werden.

Diese erste Flüssigkeitszuführvorrichtung ist mit Vorteil derart ausgebildet, dass ein Flüssigkeitsstrahl erzeugbar ist, dessen Auftreffwinkel auf die Werkstückoberfläche und dessen Durchflussmenge variierbar sind. Dadurch kann der Flüssigkeitsstrahl variiert werden, sodass die Flüssigkeitsschicht mit einer in dem Arbeitsbereich schiessenden und mit einer ausserhalb des Arbeitsbereichs strömenden Bewegung erzeugbar ist.

Aus der nachfolgenden Detailbeschreibung und der Gesamtheit der Patentansprüche ergeben sich weitere vorteilhafte Ausführungsformen und Merkmalskombinationen der Erfindung.

**Kurze Beschreibung der Zeichnungen**

Die zur Erläuterung des Ausführungsbeispiels verwendeten Zeichnungen zeigen:

Fig. 1      eine schematische Darstellung einer erfindungsgemässen Vorrichtung;

Fig. 2      eine Detailansicht der Vorrichtung aus Fig. 1;

Fig. 3      eine Detailansicht einer weiteren Vorrichtung gemäss der Erfindung und

Fig. 4      eine schematische Darstellung eines weiteren Ausführungsbeispiels der Erfindung.

Grundsätzlich sind in den Figuren gleiche Teile mit gleichen Bezugszeichen versehen.

**Wege zur Ausführung der Erfindung**

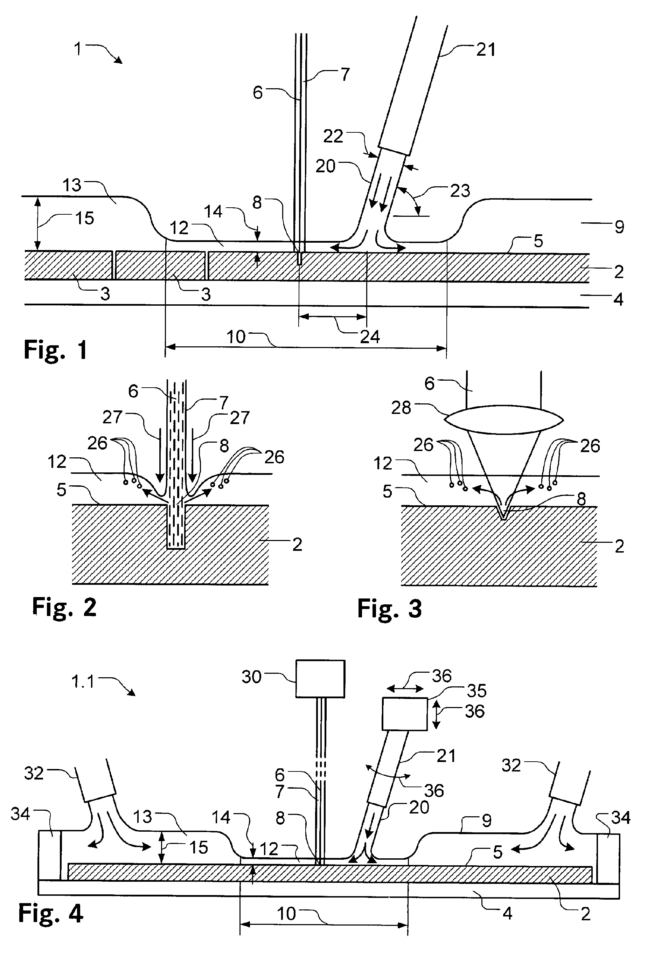

Fig. 1 zeigt eine schematische Darstellung eines Teils einer erfindungsgemässen Vorrichtung 1 zum Bearbeiten eines Werkstücks, im vorliegenden Beispiel eines Wafers 2. Bei dem Wafer handelt es sich um eine Siliziumscheibe, auf welcher in bekannter Weise eine Vielzahl integrierter Schaltkreise realisiert sind. Die Bearbeitung des Wafers 2 besteht nun im Ausschneiden dieser Schaltkreise, auch Chips 3 genannt, aus dem Wafer 2. Derartige Wafer sind in der Regel rund, haben einen Durchmesser in der Grössenordnung von einigen Dutzend bis einigen Hundert Millimetern und eine Dicke im Bereich einiger Dutzend bis einige Hundert Mikrometer.

Der Wafer 2 ist auf einem Träger 4 befestigt. Der Wafer 2 wird beispielsweise durch einen Druckunterschied ober- und unterhalb des Trägers 4 auf diesem gehalten. Oberhalb des Trägers 4 herrscht beispielsweise der Umgebungs- oder Atmosphärendruck. Unterhalb des Trägers 4 wird ein mehr oder weniger starker Unterdruck erzeugt. Da der Träger 4 selber luftdurchlässig, z.B. porös ausgebildet ist, wird der Wafer 2 auf dessen Oberfläche sozusagen angesaugt und festgehalten. Zusätzlich oder stattdessen kann der Wafer 2 mit Hilfe einer Klebefolie auf dem Träger 4 aufgeklebt werden, wobei die Folie gegebenenfalls auch luftdurchlässig ausgebildet ist.

Zum Schneiden des Wafers 2 wird ein Laserstrahl 6, beispielsweise ein Nd:YAG Laser mit einer Wellenlänge von 1.06 Mikrometer und einer Leistung von 100 Watt verwendet. Je nach konkreter Anwendung kann die Laserleistung selbstverständlich auch von einigen wenigen Watt bis hinauf in den Kilowatt-Bereich variiert werden. Ebenso kann je nach Art der Anwendung ein anderer Laser verwendet werden. Der Laserstrahl 6 wird auf einen Arbeitspunkt 8 auf der Oberfläche 5 des Wafers 2 gerichtet wobei dies in bekannter Weise zum Abtrag von Wafermaterial im Arbeitspunkt 8 und gewünschtenfalls schliesslich zur vollständigen Durchtrennung des Wafers 2 führt. Zum Schneiden des Wafers 2 werden der Laserstrahl 6 und der Wafer 2 relativ zueinander bewegt, wobei dies durch Fixieren des Wafers 2 und Verschieben des Laserstrahls 6, durch Fixieren des Laserstrahls 6 und Verschieben des Wafers 2 wie auch durch Verschieben sowohl des Laserstrahls 6 als auch des Wafers 2 erfolgen kann.

In dem in Fig. 1 dargestellten Beispiel ist der Laserstrahl 6 in bekannter Weise in einen Flüssigkeitsstrahl 7 eingekoppelt, welcher für den Laserstrahl 6 als Lichtleiter wirkt. Der Flüssigkeitsstrahl 7 wird mit einem Druck im Bereich von einigen Bar bis zu einigen tausend Bar, vorzugsweise im Bereich von 50 Bar bis 1'000 Bar erzeugt. Der Durchmesser des Flüssigkeitsstrahls 7 liegt im Submillimeter-Bereich, typischerweise zwischen 5 Mikrometer und 500 Mikrometer, vorzugsweise zwischen 20 Mikrometer und 100 Mikrometer.

Der Flüssigkeitsstrahl 7 wird, insbesondere bei Verwendung eines Nd:YAG Lasers, vorzugsweise mit Wasser erzeugt, welchem gegebenenfalls andere Stoffe beigemischt werden, um die Strahleigenschaften zu beeinflussen. Neben Wasser können aber auch andere elektrisch leitende oder elektrisch nicht leitende Flüssigkeiten verwendet werden. Öle, insbesondere Silikonöle, eignen sich beispielsweise auch zur Erzeugung des Flüssigkeitsstrahls 7.

Die Wahl der Flüssigkeit hängt auch zusammen mit dem verwendeten Laser, da die Absorption der Laserstrahlung stark von der Art der Flüssigkeit abhängen kann. D.h. es ist darauf zu achten, dass die für den Flüssigkeitsstrahl 7 verwendete Flüssigkeit die verwendete Laserstrahlung nicht oder nur wenig absorbiert.

Auf der Oberfläche 5 des Wafers 2 bzw. der Chips 3 wird nun erfindungsgemäss eine Flüssigkeitsschicht 9 erzeugt, welche in einem Bereich um den Arbeitspunkt 8 herum, dem sogenannten Arbeitsbereich 10 dünner ist als ausserhalb des Arbeitsbereiches 10. Die Flüssigkeitsschicht 9 im Arbeitsbereich 10 wird nachfolgend als Arbeitsschicht 12 der Dicke 14 und jener Bereich der Flüssigkeitsschicht 9 ausserhalb des Arbeitsbereiches 10 als Spülschicht 13 der Dicke 15 bezeichnet.

Erzeugt wird die unterschiedlich dicke Flüssigkeitsschicht 9 mittels eines Flüssigkeitsstrahls 20, welcher beispielsweise mit Hilfe eines Rohres 21 auf die Oberfläche 5 des Wafers 2 aufgebracht wird. Der Flüssigkeitsstrahl 20 wird in der Nähe des Arbeitspunktes 10 auf den Wafer 2 aufgebracht, wobei die Distanz 24 zum Arbeitspunkt 10 weder zu gross, noch zu klein gewählt werden darf. Allerdings ist die Bandbreite für die konkrete Wahl der Distanz 24 ziemlich gross. D.h. die Distanz 24 kann sowohl sehr klein als auch sehr gross gewählt werden. Es ist lediglich zu beachten, dass sich der Arbeitspunkt 8 innerhalb des Arbeitsbereichss 10, d.h. innerhalb des Bereichs der Flüssigkeitsschicht mit der Dicke 14 befindet. Auch die Geschwindigkeit der Relativbewegung des Laserstrahls 6 und des Wafers 2 kann die Wahl der Distanz 24 beeinflussen, damit der Arbeitspunkt 8 in jedem Fall innerhalb des Arbeitsbereichs 10 liegt.

Der Fluss der aufgebrachten Flüssigkeit ist durch die Pfeile angedeutet. Der Auftreffwinkel 23 und die Durchflussmenge des Flüssigkeitsstrahls 20 können variiert werden. Sie werden derart gewählt, dass sich die Flüssigkeit in der Arbeitsschicht 12 schiessend (Froude-Zahl grösser als 1) und in der Spülschicht 13 strömend (Froude-Zahl kleiner als 1) bewegt, wobei der Übergang von der Arbeitsschicht 12 zur Spülschicht 13 mehr oder weniger sprungartig verläuft.

Bei einem runden Wafer 2 mit einem Durchmesser von 200 Millimetern bis 300 Millimetern wird die Distanz 24 im Bereich von etwa 5 Millimetern bis 50 Millimetern gewählt. Das Rohr 21 ist derart ausgebildet, dass der Durchmesser 22 des Flüssigkeitsstrahls 20 zwischen 0,5 Millimeter und 4 Millimeter liegt. Mit einem Auftreffwinkel 23 zwischen 45 Grad und 90 Grad und einer Durchflussmenge des Flüssigkeitsstrahls 20 zwischen 20 Milliliter pro Minute und 500 Milliliter pro Minute liegt die Dicke 14 der Arbeitsschicht 12 im Bereich von 0,01 Millimeter bis 0,5 Millimeter und die Dicke 15 der Spülschicht 13 im Bereich von 0,5 Millimeter bis 5 Millimeter.

Fig. 2 zeigt eine Detailansicht des Wafers 2 im Bereich des Arbeitspunktes 8. Der im Flüssigkeitsstrahl 7 eingekoppelte Laserstrahl 6 füllt den Flüssigkeitsstrahl 7 praktisch vollständig aus, was durch die gestrichelten Linien angedeutet ist. Der Laserstrahl 6 durchquert die Arbeitsschicht 12, trifft auf die Oberfläche des Wafers 2 und trägt dort Material ab, indem dieses durch die vom Laserstrahl 6 zugeführte Energie aufschmilzt. Hierbei entstehen kleine Partikel 26, der sogenannte Auswurf, welche aus geschmolzenem Wafermaterial bestehen können und von der schiessend fliessenden Arbeitsschicht 12 sogleich gekühlt und weggespült werden. Dadurch wird verhindert, dass sich die Partikel 26 auf der Oberfläche 5 des Wafers 2 absetzen und sich dort wieder mit dem Wafer 2 verbinden. Diese Partikel 26 werden von der Arbeitsschicht 12 bis zur Spülschicht 13 und von dieser vom Wafer weggespült. Durch die gewählte Dicke 15 der Spülschicht 13 ist sichergestellt, dass kein Bereich der Waferoberfläche austrocknet, sondern jederzeit mit einer Schicht der Flüssigkeit bedeckt ist. Dadurch kann das Absetzen der Partikel 26 auch im äusseren Bereich des Wafers 2 wirksam verhindert werden. Das Resultat ist eine einhundert Prozent reine Oberfläche 5 des Wafers 2.

Es ist zu beachten, dass der Flüssigkeitsstrahl 7 die Luft an seiner Oberfläche mitreisst. Die vom Flüssigkeitsstrahl 7 mitgerissene Luft ist durch die Pfeile 27 dargestellt. Diese mitgerissene Luft verdrängt beim Auftreffen des Flüssigkeitsstrahls 7 auf die Arbeitsschicht 12 einen Teil der Flüssigkeit der Arbeitsschicht 12 rund um den Arbeitspunkt 8 herum, sodass der Flüssigkeitsstrahl 7 quasi verlängert wird. Der Flüssigkeitsstrahl 7 ragt sozusagen in den Arbeitsbereich 12 hinein und reicht fast bis zur Werkstückoberfläche herunter. Dadurch kann der Laserstrahl 6 länger in dem Flüssigkeitsstrahl 7 geführt werden, was geringere Energieverluste des Laserstrahls 6 zur Folge hat.

In Fig. 3 ist ein weiteres Beispiel für eine erfindungsgemässe Vorrichtung dargestellt. Bei dieser Vorrichtung ist der Laserstrahl 6 nicht in einen Flüssigkeitsstrahl eingekoppelt, sondern wird durch die Luft geschickt. Bei diesem Beispiel ist der Laserstrahl im Bereich oberhalb des Wafers nicht auf einige Mikrometer konzentriert, sondern hat einen Durchmesser im Bereich einiger Millimeter bis einige Zentimeter. Um die Energie im Bereich der Waferoberfläche zu bündeln, damit ein Materialabtrag erfolgen kann, umfasst die Vorrichtung eine Linse 28, welche den Laserstrahl 6 fokussiert. Der Laserstrahl 6 und die Linse 28 werden so gewählt, dass sich der Fokuspunkt auf oder unterhalb der Waferoberfläche befindet und der fokussierte Laserstrahl genug Energie für einen Materialabtrag aufweist. Der Fokuspunkt kann beispielsweise durch eine Höhenverstellung der Linse 28 variiert werden.

Bei diesem Beispiel wird der Laserstrahl nicht in einem Wasserstrahl geführt und muss lediglich die dünne Flüssigkeitsschicht im Arbeitspunkt durchqueren. Je nach Anwendung können in diesem Fall auch andere Laser verwendet werden.

Fig. 4 zeigt eine etwas umfassendere Darstellung eines weiteren Beispiels für eine erfindungsgemässe Vorrichtung 1.1. Der im Flüssigkeitsstrahl 7 eingekoppelte Laserstrahl 6 wird mit Hilfe einer im Stand der Technik bekannten Strahlerzeugungsvorrichtung 30 erzeugt. Diese umfasst nicht nur die (nicht dargestellten) Mittel zur Erzeugung der Laserstrahlung und damit des Laserstrahls 6 im gewünschten Wellenlängenbereich und mit der erforderlichen Energie, sie umfasst auch die (nicht dargestellten) Mittel zur Erzeugung des Flüssigkeitsstrahls 7 mit den gewünschten Eigenschaften sowie die (nicht dargestellten) Mittel zum Einkoppeln des Laserstrahls 6 in den Flüssigkeitsstrahl 7.

Zur Erzeugung der Flüssigkeitsschicht 9 auf der Oberfläche 5 des Wafers 2 ist bei diesem Beispiel neben der Flüssigkeitszuführvorrichtung 35 mit dem Rohr 21 eine weitere Flüsigkeitszuführvorrichtung vorgesehen, welche eine oder eine Mehrzahl von Wasserauslässen wie beispielsweise Röhren, Schläuche oder spezielle Düsen umfasst, wobei in Fig. 4 zwei Düsen 32 dargestellt sind. Die Düsen 32 erzeugen die Spülschicht 13. Deren Dicke 15 wird kontrolliert durch die Höhe der Umrandung 34, welche als Teil des Trägers 4 oder als separater Teil der Vorrichtung 1.1 ausgebildet sein kann. Die Umrandung 34 ist beispielsweise derart ausgebildet, dass überschüssige Flüssigkeit durch spezielle Abflüsse oder über den Rand der Umrandung 34 abläuft. Um die Arbeitsschicht 12 der geringeren Dicke 14 zu erzeugen, umfasst auch die Vorrichtung 1.1 eine Flüssigkeitszuführvorrichtung 35, mit welcher ein Flüssigkeitsstrahl 20 erzeugt und mit dem Rohr 21 auf die Waferoberfläche aufgebracht werden kann. Trifft der Flüssigkeitsstrahl 20 auf die Spülschicht 13, beeinflusst dies die Strömungsverhältnisse in der Flüssigkeitsschicht 9 derart, dass sich um den Auftreffpunkt des Flüssigkeitsstrahls 20 herum wiederum eine dünne Arbeitsschicht 12 mit schiessender Bewegung der Flüssigkeit ausbildet. Auch hier definiert dieser Bereich den sogenannten Arbeitsbereich. Um die Eigenschaften des Flüssigkeitsstrahls 20 zu beeinflussen, ist die Flüssigkeitszuführvorrichtung 35 beispielsweise derart ausgebildet, dass sowohl die Durchflussmenge des Flüssigkeitsstrahls 20 als auch die horizontale und vertikale Position sowie der Auftreffwinkel 23 des Flüssigkeitsstrahls 20 variierbar sind. Dies ist durch die Pfeile 36 angedeutet. Die Flüssigkeitszuführvorrichtung 35 ist bewegungsmässig bevorzugt mit der Strahlerzeugungsvorrichtung 30 gekoppelt, sodass der Auftreffpunkt des Flüssigkeitsstrahls 20 in Bezug auf den Arbeitspunkt 8 im Wesentlichen konstant bleibt.

Mittels der Düsen 32 bzw. des Rohrs 21 können durchaus verschiedene Flüssigkeiten auf den Wafer 2 aufgebracht werden. Typischerweise handelt es sich jedoch um dieselbe Flüssigkeit.

Die zur Erzeugung der Flüssigkeitsschicht auf der Waferoberfläche notwendige Flüssigkeit kann auch auf andere Weise auf den Wafer aufgebracht werden. Es wäre beispielsweise möglich, den Flüssigkeitsstrahl 20, welcher den schiessend strömenden Arbeitsbereich erzeugt, mit Hilfe mehrerer Einzelstrahlen zu erzeugen. Denkbar wäre beispielsweise auch eine Vorrichtung, die einen ringförmigen Flüssigkeitsstrahl erzeugt, der in einem bestimmten Abstand rund um den Laserstrahl herum angeordnet ist. Anstelle der Düsen 32 könnte zur Erzeugung der Spülschicht 13 beispielsweise auch eine Vielzahl von Düsen in die Umrandung 34 integriert sein.

Zusammenfassend ist festzustellen, dass es die Erfindung erlaubt, den beim Bearbeiten eines Werkstücks mit einer Laserstrahlung entstehenden Auswurf mit einer genügend dicken Flüssigkeitsschicht wegzuspülen und gleichzeitig sicher zu stellen, dass die Flüssigkeitsschicht im Bereich des Arbeitspunktes genügend dünn ist, dass eine zur Bearbeitung des Werkstücks ausreichende Energiemenge der Laserstrahlung auf das Werkstück aufgebracht werden kann.

**Patentansprüche**

1. Verfahren zur Bearbeitung eines Werkstücks (2) mit einer Laserstrahlung (6), bei welchem die Laserstrahlung auf eine Oberfläche (5) des Werkstücks gerichtet und das Werkstück in einem Arbeitspunkt (8) bearbeitet wird, **dadurch gekennzeichnet, dass** auf der Oberfläche des Werkstücks mit einer Flüssigkeit eine Flüssigkeitsschicht (9) erzeugt wird.

2. Verfahren nach Anspruch 1, **dadurch gekennzeichnet, dass** die Flüssigkeitsschicht (9) derart erzeugt wird, dass eine erste Dicke (14) der Flüssigkeitsschicht in einem Arbeitsbereich (10) um den Arbeitspunkt kleiner ist als eine zweite Dicke (15) der Flüssigkeitsschicht ausserhalb dieses Arbeitsbereichs.

3. Verfahren nach Anspruch 1 oder 2, **dadurch gekennzeichnet, dass** die Laserstrahlung in einen Flüssigkeitsstrahl (7) eingekoppelt und der Flüssigkeitsstrahl mit der eingekoppelten Laserstrahlung auf die Oberfläche des Werkstücks gerichtet wird.

4. Verfahren nach einem der Ansprüche 1 bis 3, **dadurch gekennzeichnet, dass** die Flüssigkeitsschicht auf der Oberfläche des Werkstücks mit Wasser, insbesondere mit deionisiertem Wasser, erzeugt wird.

5. Verfahren nach einem der Ansprüche 1 bis 4, **dadurch gekennzeichnet, dass** ein Wafer (2) bearbeitet wird, wobei insbesondere ein Siliziumwafer in eine Vielzahl von Chips (3) geschnitten wird.

6. Verfahren nach einem der Ansprüche 1 bis 5, **dadurch gekennzeichnet, dass** die zweite Dicke der Flüssigkeitsschicht reguliert wird, indem der Flüssigkeit oberflächenspannungsbeeinflussende Stoffe beigefügt werden und/oder indem eine zugeführte und/oder abfliessende Flüssigkeitsmenge variiert wird.

7. Verfahren nach einem der Ansprüche 1 bis 6, **dadurch gekennzeichnet, dass** die Flüssigkeitsschicht erzeugt wird, indem mit einer ersten Flüssigkeitszuführvorrichtung (21) die Flüssigkeit in einer Nähe (24) des Arbeitspunktes auf das Werkstück aufgebracht wird.

8. Verfahren nach Anspruch 7, **dadurch gekennzeichnet, dass** mit einer zweiten Flüssigkeitszuführvorrichtung (32) eine träge Flüssigkeitsschicht der zweiten Dicke erzeugt wird, wobei die in der Nähe des Arbeitspunktes aufgebrachte Flüssigkeit die Dicke der Flüssigkeitsschicht in dem Arbeitsbereich auf die erste Dicke reduziert.

**9.** Verfahren nach Anspruch 7 oder 8, **dadurch gekennzeichnet, dass** die Flüssigkeit in einem Strahl (21) auf das Werkstück aufgebracht wird, wobei ein Auftreffwinkel (23) und eine Durchflussmenge des Strahls derart gewählt werden, dass sich die Flüssigkeitsschicht in dem Arbeitsbereich schiessend und ausserhalb des Arbeitsbereichs strömend bewegt.

**10.** Verfahren nach Anspruch 9, **dadurch gekennzeichnet, dass** die erste Dicke der Flüssigkeitsschicht und/oder eine Grösse des Arbeitsbereichs reguliert wird indem der Auftreffwinkel und/oder die Durchflussmenge des Strahls variiert wird.

**11.** Verfahren nach Anspruch 10, **dadurch gekennzeichnet, dass** der Strahl mit einem Durchmesser (22) zwischen 0.5 Millimeter und 4 Millimeter erzeugt wird, wobei der Auftreffwinkel des Strahls zwischen 45 Grad und 90 Grad und dessen Durchflussmenge zwischen 1 Milliliter pro Minute und 10 Liter pro Minute, insbesondere zwischen 20 Milliliter pro Minute und 500 Milliliter pro Minute variiert wird.

**12.** Vorrichtung (1) zur Bearbeitung eines Werkstücks (2) mit einer Laserstrahlung (6), welche auf eine Oberfläche (5) des Werkstücks richtbar ist, wobei das Werkstück in einem Arbeitspunkt (8) bearbeitbar und die Laserstrahlung insbesondere in einem Flüssigkeitsstrahl (7) eingekoppelt ist, **dadurch gekennzeichnet, dass** die Vorrichtung Mittel (21) zur Erzeugung einer Flüssigkeitsschicht (9) auf der Oberfläche des Werkstücks umfasst.

**13.** Vorrichtung nach Anspruch 12, **dadurch gekennzeichnet, dass** die Mittel zur Erzeugung der Flüssigkeitsschicht derart ausgebildet sind, dass eine erste Dicke (14) der Flüssigkeitsschicht in einem Arbeitsbereich (10) um den Arbeitspunkt kleiner ist als eine zweite Dicke (15) der Flüssigkeitsschicht ausserhalb dieses Arbeitsbereichs.

**14.** Vorrichtung nach Anspruch 12 oder 13, **dadurch gekennzeichnet, dass** sie eine zweite Flüssigkeitszuführvorrichtung (32) zur Erzeugung einer trägen Flüssigkeitsschicht der zweiten Dicke umfasst.

**15.** Vorrichtung nach einem der Ansprüche 12 bis 14, **dadurch gekennzeichnet, dass** sie zur Bearbeitung eines Wafers (2), insbesondere zum Schneiden eines Siliziumwafers in eine Vielzahl von Chips (3) ausgebildet ist.

**16.** Vorrichtung nach Anspruch 12 bis 15, **dadurch gekennzeichnet, dass** sie zur Erzeugung der Flüssigkeitsschicht mit einer Flüssigkeit eine erste Flüssigkeitszuführvorrichtung (21) umfasst, welche derart ausgebildet ist, dass die Flüssigkeit in einer Nähe (24) des Arbeitspunktes auf das Werkstück aufbringbar ist.

**17.** Vorrichtung nach Anspruch 16, **dadurch gekennzeichnet, dass** die erste Flüssigkeitszuführvorrichtung derart ausgebildet ist, dass ein Strahl (20) der Flüssigkeit erzeugbar ist, wobei ein Auftreffwinkel (23) und eine Durchflussmenge des Strahls derart variierbar sind, dass die Flüssigkeitsschicht mit einer in dem Arbeitsbereich schiessenden und mit einer ausserhalb des Arbeitsbereichs strömenden Bewegung erzeugbar ist.

**Fig. 1**

**Fig. 2**

**Fig. 3**

**Fig. 4**

**EP 1 598 140 A1**

# EUROPÄISCHER RECHERCHENBERICHT

Nummer der Anmeldung

EP 04 40 5312

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 4 766 009 A (HANAZONO MASANOBU ET AL) 23. August 1988 (1988-08-23)<br><br>* das ganze Dokument *<br>----- | 1,3,4,7, 9,12,16, 17 | B23K26/14 H01L21/00 |
| X | US 3 991 296 A (KOJIMA YOSHITOMO ET AL) 9. November 1976 (1976-11-09) * das ganze Dokument *<br>----- | 1,4,5, 12,15 | |
| X | US 2003/129814 A1 (MIZUKOSHI MASATAKA) 10. Juli 2003 (2003-07-10) * das ganze Dokument *<br>----- | 1,4,5,9, 12,15 | |
| X | DE 41 38 468 A (STIFTUNG FUER LASERTECHNOLOGIE) 3. Juni 1993 (1993-06-03)<br><br>* das ganze Dokument *<br>----- | 1-4, 6-10, 12-14, 16,17 | |
| X | US 5 744 781 A (YEATON ROBERT L) 28. April 1998 (1998-04-28) * das ganze Dokument *<br>----- | 1,2,4, 12,13 | RECHERCHIERTE SACHGEBIETE (Int.Cl.7)<br><br>B23K H01L |

Der vorliegende Recherchenbericht wurde für alle Patentansprüche erstellt

| Recherchenort | Abschlußdatum der Recherche | Prüfer |
|---|---|---|
| München | 13. Oktober 2004 | Caubet, J-S |

**ANHANG ZUM EUROPÄISCHEN RECHERCHENBERICHT
ÜBER DIE EUROPÄISCHE PATENTANMELDUNG NR.**

EP 04 40 5312

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-10-2004

| Im Recherchenbericht angeführtes Patentdokument | | Datum der Veröffentlichung | Mitglied(er) der Patentfamilie | | Datum der Veröffentlichung |
|---|---|---|---|---|---|
| US 4766009 | A | 23-08-1988 | JP<br>JP<br>JP | 1604835 C<br>2030386 B<br>61030672 A | 13-05-1991<br>05-07-1990<br>12-02-1986 |
| US 3991296 | A | 09-11-1976 | JP | 51057283 A | 19-05-1976 |
| US 2003129814 | A1 | 10-07-2003 | JP | 2003203889 A | 18-07-2003 |
| DE 4138468 | A | 03-06-1993 | DE | 4138468 A1 | 03-06-1993 |
| US 5744781 | A | 28-04-1998 | KEINE | | |

EPO FORM P0461

Für nähere Einzelheiten zu diesem Anhang : siehe Amtsblatt des Europäischen Patentamts, Nr.12/82